# EUROPÄISCHE PATENTSCHRIFT

(11) **EP 0 424 620 B1**
(45) Veröffentlichungstag und Bekanntmachung des Hinweises auf die Patenterteilung: **06.09.1995**
(21) Anmeldenummer: 90115447.6
(22) Anmeldetag: 11.08.1990
(51) Int. Cl.: C23C 16/50, H01J 37/32, C23C 16/04, G02B 1/10, C23C 16/44, H01L 21/00

(54) **Verfahren und Anlage zum chemischen Beschichten von einander gegenüberliegenden Oberflächenbereichen eines Werkstückes**
Process and apparatus for chemically coating opposing faces of a workpiece
Procédé et dispositif pour le revêtement par moyen chimique des surfaces opposés d'une pièce

(30) Priorität: 22.09.1989 DE 3931713
(43) Veröffentlichungstag der Anmeldung: 02.05.1991
(73) Patentinhaber: BALZERS AKTIENGESELLSCHAFT, 9496 Balzers (LI)
(72) Erfinder: Thiebaud, Francis, Dr., CH-9479 Oberschan (CH); Zimmermann, Heinrich, Dr., CH-9470 Buchs (CH)
(74) Vertreter: Troesch, Jacques J., Dr. sc. nat.

(56) Entgegenhaltungen:
- EP-A- 0 090 081
- EP-A- 0 293 229
- WO-A-87/01738
- WO-A-89/03587
- DE-A- 3 833 501
- GB-A- 2 178 062
- US-A- 4 289 598
- US-A- 4 512 284

## Beschreibung

Die vorliegende Erfindung betrifft ein Verfahren zum Beschichten nach dem Oberbegriff von Anspruch 1 sowie eine Anlage hierfür nach dem Oberbegriff von Anspruch 10 sowie Anwendungen des Verfahrens bzw. der Anlage.

Plasmaunterstützte Dampfabscheidungsverfahren sind bekannt, ebenso wie die hierfür eingesetzten Anlagen, wozu beispielsweise auch auf "Plasma deposition of inorganic thin films", Alan R. Reinberg, Ann. Rev.Mater.Sci. 1979, S. 341-372, hingewiesen wird.

Zur Erzeugung des Plasmas ist es dabei auch bekannt, ein elektrisches Feld zwischen zwei Elektroden zu erzeugen, um dem Gasgemisch in der Vakuumkammer die zur Plasmabildung notwendige Energie zuzuführen. Der zwischen den Elektroden liegende Raum kann grundsätzlich in zwei Dunkelräume unmittelbar im Bereich der Elektroden und den Plasmaraum, der zwischen den Dunkelräumen liegt, eingeteilt werden. Während im Plasmaraum eine hohe Dichte elektrischer Ladungsträger vorliegt, die Raumladungsdichte, sich aus der Ladungsbilanz pro Raumeinheit ergebend, aber Null ist, weisen die Dunkelräume eine ausgesprochene Raumladungsdichte auf.

Wegen der nicht verschwindenden Ladungsbilanz in den Dunkelräumen nimmt der Plasmaraum das Plasmapotential an. Innerhalb des Plasmaraumes ist das Potential im wesentlichen konstant. Der Plasmaraum ist ein für den Fachmann klar definierter Raum, wozu z.B. auf "Glow Discharge Processes", Brian Chapman, John Wiley & Sons (1980), S. 77-80, verwiesen sei.

Bei der Werkstückbeschichtung mit dem obgenannten Verfahren, im weiteren PECVD (plasma-enhanced chemical vapor deposition) genannt, ist es üblich, die Werkstücke auf einer der Elektroden anzuordnen. Zur Beschichtung mit leitenden Schichten werden die Elektroden mit Gleich- oder Wechselspannung betrieben, während für die Beschichtung mit isolierenden Materialien eine Wechselspannungsspeisung vorgesehen wird.

Aus der US-A-3 847 652 ist ein PECVD-Verfahren mit entsprechender Anordnung bekannt geworden, um Osmosemembrane herzustellen. Das Plasma strömt von einer Seite gegen einen Träger, auf welchem die Membrane beschichtet werden soll, während das Monomergas von der Gegenseite zugeleitet wird. Die Plasmaerzeugung erfolgt mittels Hochfrequenz an einem Elektrodenpaar, entfernt vom Träger.

Die Beschichtung der Membrane wird gezielt auf einer Seite der Trägerplatte gebildet, wobei erläutert ist, bei unterschiedlicher Flächenausbildung des Trägers, welche Fläche sich für die Beschichtung besser eigne.

Im weiteren ist es aus der DE-A-33 21 906 bekannt, metallisches Pulver mit einem synthetischen Film durch plasmaunterstützte chemische Dampfabscheidung zu beschichten, indem es in einem rotierenden Vakuumbehälter zwischen Elektroden zur Erzeugung des Plasmas umgerührt wird, womit das Pulver allseitig beschichtet wird.

Wie erwähnt wurde, ist es beim PECVD üblich, zu beschichtende Werkstücke, die, im Gegensatz zu Pulver, nicht im Prozessraum umgerührt werden können, auf der einen Elektrode anzuordnen. Der Nachteil davon ist, dass die Werkstücke nur von einer Seite beschichtet werden und dass mithin ein nachmaliges Wenden notwendig ist, wenn sie beidseitig zu beschichten sind. Zudem ist das gleiche bzw. gleichmässige Beschichten unterschiedlich hoher Werkstücke oder von Werkstücken mit gewölbten Oberflächen, wie später gezeigt wird, schwierig. Eine dreidimensionale Beschichtung, wie sie gemäss der DE-A-33 21 906 für Pulverkörner bekannt ist, bei welcher die Pulverkörner wegen der Rotationsbewegung des Reaktionsgefässes im Plasmaraum und in den Dunkelräumen hin und her gerührt werden, ist klar für die Beschichtung von Werkstücken, wie Linsen, Filtergläsern etc., nicht möglich.

Aus der WO-A-87/01738 ist ein chemisches Abscheideverfahren mittels Mikrowellenentladung bekannt, wobei ein zu beschichtendes Substrat auf einem Substratträgertisch abgelegt wird, über dem sich der Entladungsraum befindet.

Bei einer aus der GB-A-2 178 062 bekannten Vorrichtung wird zur zweiseitigen Beschichtung das zu behandelnde Substrat zwischen zwei Elektroden angeordnet und auf Bezugspotential gebracht. Bei dieser Anordnung wirken eine obere Elektrode einerseits und das Substrat andererseits als eine Entladungsstrecke für die obere Substratoberfläche, die untere Seite des Substrats mit einer unteren Elektrode als zweite Entladungsstrecke der unteren Substratseite.

Ein weiteres Beschichtungsverfahren ist aus der US-A-4 512 284 bekannt. Auch bei diesem Verfahren wird innerhalb eines Rezipienten mittels Elektroden ein Plasma erzeugt.

Aus der US-A-4 289 598 ist ein reaktives Aetzverfahren bekannt, bei dem die zu behandelnden Werkstücke zwischen kammartig angeordneten Parallelelektrodenpaaren mittig im Plasmaraum gehalten werden.

Aus der US-A-4 361 595 ist es nun bekannt, in einem Gas-Vakuumrezipienten zwischen zwei Elektroden eine DC- oder AC-Entladung zu erzeugen. Zur Bildung je einer abrasiven Schicht auf SiOₓ auf Kunststoffscheiben mittels eines PECVD-Verfahrens werden, in einer Ausführungsvariante, zwei zu beschichtende Kunststoffscheiben in gewissen Ausführungsvarianten direkt aufeinandergelegt und in den zwischen den Elektroden gebildeten Entladungsraum eingebracht.

Dementsprechend liegt der Erfindung die Aufgabe zugrunde, ein Verfahren bzw. eine Vorrichtung obgenannter Art vorzuschlagen, mittels welchen es möglich ist, Werkstückoberflächen weitgehend unabhängig von der Ausbildung bzw. der Anordnung zu beschichtender Flächen im wesentlichen gleichmässig und gleichzeitig zu beschichten.

Dies wird beim Verfahren eingangs genannter Art dadurch erreicht, dass es nach dem kennzeichnenden Teil von Anspruch 1 ausgeführt wird.

Die Erfindung geht von der an sich bekannten Erkenntnis aus, dass in den an die Elektroden anschliessenden Raumgebieten, den Dunkelräumen, wohl die höchste Abscheidungsrate beobachtet wird, wenn in einem dieser Räume das zu beschichtende Werkstück angeordnet wird, wie unmittelbar auf der einen der Elektroden, dass aber in diesen an die Elektroden anschliessenden Räumen der Abscheidungsgradient in Funktion zunehmenden Abstandes von einer betrachteten Elektrode gross ist, was eben zu den erwähnten Problemen führt.

Nun wird aber erkannt, dass der Abscheidungsratengradient, in Funktion des von einer Elektrode her betrachtet zunehmenden Abstandes-, im Plasmaraum mindestens genähert Null wird, d.h. dass im Plasmaraum die Abscheidungsrate, wenn auch geringer als im Dunkelraum, so doch weitgehendst abstandsunabhängig ist, womit in herkömmlichen derartigen Prozessen die genannten Probleme höchst einfach gelöst werden können, wenn man vom vorerst offensichtlichen Kriterium wegkommt, die höchste Abscheidungsrate aus Gründen vermeintlich optimaler Prozessökonomie, in den Dunkelräumen, ausnützen zu wollen.

Durch die erfindungsgemässe Abkehr vom "straight forwards"-Optimieren - grösstmögliche Beschichtung pro Zeiteinheit - werden nun weitere höchst vorteilhafte Möglichkeiten eröffnet.

Die erfindungsgemässe Erkenntnis erlaubt nun aber auch, den Plasmaraum grundsätzlich zum Anordnen von Werkstücken auszunützen, räumlich gestaffelt, womit gleichzeitig wesentlich mehr Werkstücke bearbeitet werden können, als wenn ihr Anordnen auf die zur Verfügung stehende zweidimensionale Fläche einer der Elektroden beschränkt ist.

Obwohl es physikalisch durchaus möglich ist, PECVD-Verfahren mittels einer Gleichspannungsentladung vorzunehmen, ist dies bei der Beschichtung mit isolierenden Materialien aus Elektrodenbeschichtungsgründen und der Bildung von Kapazitäten durch die sich bildenden Schichten als Dielektrikum problematisch.

Allerdings ist das erfindungsgemässe Verfahren nicht auf Beschichtungsvorgänge für isolierende Materialien beschränkt, sondern kann durchaus auch für die Beschichtung mit leitenden Materialien eingesetzt werden, wo, wie erwähnt, mit einer Gleichspannungsentladung gearbeitet werden kann.

Vorzugsweise wird dies aber mit Hochfrequenz bis hin in den Mikrowellenbereich vorgenommen, insbesondere wenn die Beschichtung mit isolierendem Material erfolgt.

Obwohl es in manchen Fällen angezeigt ist, die Flächen während der Beschichtung zu bewegen, ist es mit ein wesentliches Element der vorliegenden Erfindung, dass die Flächen während des Prozesses stationär gehalten werden können und trotzdem im wesentlichen gleich und gleichzeitig beschichtet werden.

Nun ist es ebenfalls bekannt, dass Eigenschaften des Plasmaraumes, hier interessierend vor allem dessen Ausdehnung, durch Anlegen eines magnetischen Induktionsfeldes B̅ im Reaktionsraum beeinflusst werden können. Hierzu sei beispielsweise auf den Artikel "Magnetic field effects in the plasma-enhanced chemical vapor deposition of boron nitride" von T.H. Yuzuriha et al., J.Vac.Sci.Technol. A 3(6), Nov./Dez. 1985, hingewiesen.

Nachdem erfindungsgemäss schon erkannt wurde, welche Vorteile die Beschichtung im Plasmaraum gegenüber der Beschichtung in einem der Dunkelräume aufweist, wird erfindungsgemäss ein weiterer Schritt gegangen, indem man die Ausbildung des Plasmaraumes optimiert, insbesondere in seiner räumlichen Ausdehnung.

Dies wird mittels eines Magnetfeldes im Plasmaraum vorgenommen. Man erreicht dadurch, dass sich der Plasmaraum homogen über einen grösseren Bereich des Reaktionsraumes erstreckt, womit der zur Verfügung stehende Raum zum Anordnen zu beschichtender Werkstücke vergrössert wird.

Eine erfindungsgemässe Anlage zeichnet sich zur Lösung der oben gestellten Aufgabe nach dem Wortlaut von Anspruch 10 aus.

Eine spezifisch erprobte und sich als höchst geeignet herausgestellte Verfahrensvariante ist in Anspruch 7 spezifiziert, während eine ebenso erprobte Anwendung des Verfahrens bzw. der Anlage in Anspruch 20 spezifiziert ist.

Die Erfindung wird anschliessend beispielsweise anhand von Figuren erläutert.

In den Figuren zeigen:
- Fig. 1: eine an sich bekannte Prozesskammer, schematisch und im Querschnitt, zur Durchführung eines PECVD-Verfahrens, zur Erläuterung der unterschiedlichen Beschichtungsratenverhältnisse im Zusammenhang mit Fig. 2,
- Fig. 2: über einer, wie in Fig. 1 beispielsweise eingetragenen Raumachse x, senkrecht zur einen der Elektroden, die qualitativen Verhältnisse der Beschichtungsrate R,
- Fig. 3: an der Prozesskammer gemäss Fig. 1 eine erfindungsgemässe Anordnung von gleichzeitig zwei- und/oder mehrseitig zu beschichtenden Werkstücken,
- Fig. 4: an der Kammer gemäss Fig. 1 das erfindungsgemässe Anordnen von Werkstücken zur gleichzeitigen, gleichmässigen Beschichtung,
- Fig. 5: die beispielsweise Anordnung von Magneten zur Erzeugung eines gezielt die Plasmaverteilung beeinflussenden magnetischen Induktionsfeldes B̅.

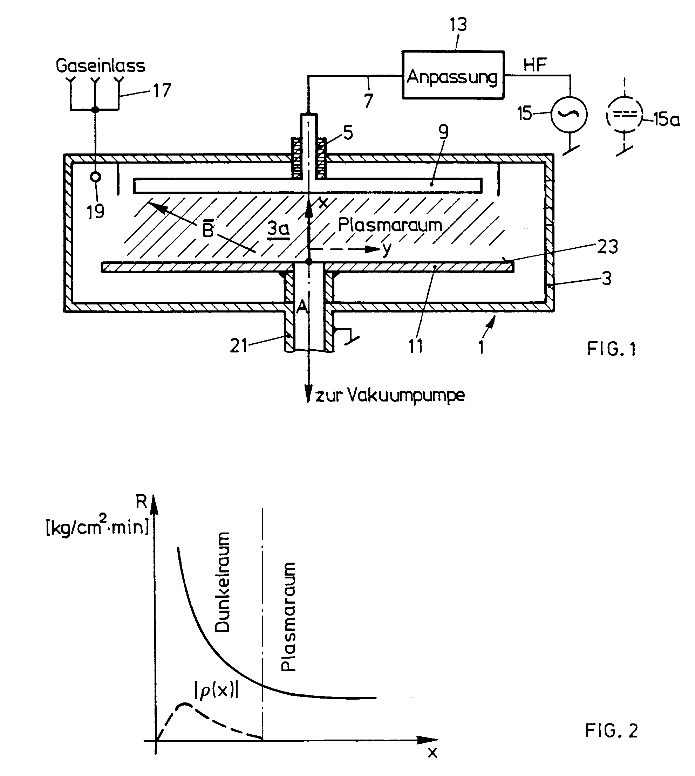

In Fig. 1 ist schematisch, im Querschnitt, eine bekannte Prozesskammer 1 zur plasmaunterstützten chemischen Dampfabscheidung (PECVD) dargestellt. Sie umfasst ein Kammergehäuse 3, durch welches, wie mittels einer isolierten Durchführung 5, die elektrische Speisung 7 einer der Elektroden 9, hier als Plattenelektrode dargestellt, durchgeführt ist. Der Elektrode 9 gegenüberliegend ist eine zweite Elektrode 11 vorgesehen, welche beispielsweise zusammen mit dem Gehäuse 3 auf Masse gelegt ist.

Insbesondere für die Beschichtung mit einem isolierenden Schichtmaterial ist die Speisung 7, über ein Anpassnetzwerk 13, mit einem AC-Generator 15 verbunden, der im genannten Fall bevorzugterweise ein Hochfrequenzsignal erzeugt. Wenn vom Prozess her geeignet, insbesondere vom Beschichtungsmaterial, kann anstelle des Wechselsignalgenerators 15 ein Gleichspannungsgenerator 15a, wie gestrichelt dargestellt, vorgesehen werden, allenfalls dann unter Weglassung des Anpassnetzwerkes 13.

Zur Ausführung des PECVD-Prozesses sind Gaseinlässe 17, gespiesen aus einem oder mehreren Gastanks, vorgesehen, um das Reaktionsgas in die Prozesskammer 3 mit zwischen den Elektroden liegendem Reaktionsraum 3a durch schematisch dargestellte Einlässe 19 gesteuert zuzuführen. In der hier dargestellten Ausführungsvariante ist die Prozesskammer zylindrisch aufgebaut, und koaxial zur Zylinderachse A ist ein Evakuierungsanschluss 21 vorgesehen, in bekannter Art und Weise mit einer Vakuumpumpe und Reinigungsstufen zur Reinigung des abgepumpten Gases während des Prozesses verbunden. Wie erwähnt, stellt sich beim bekannten Betrieb einer solchen bekannten Kammer für ein PECVD-Verfahren zwischen den Elektroden 9 und 11 der rein qualitativ dargestellte schraffierte Plasmaraum ein, der sich durch eine hohe Dichte von Ladungsträgern auszeichnet, bei dem die Raumladungsdichte ρ, mindestens genähert, Null ist.

In Fig. 1 ist eine x-Achse mit Nullpunkt auf der Oberfläche der Elektrode 11 eingetragen, bezüglich welcher Fig. 2 dargestellt ist.

In Fig. 2 ist in Funktion der x-Koordinate gemäss Fig. 1 vorerst gestrichelt und rein qualitativ die Raumladungsdichte ρ(x) dargestellt. Sie ist im elektrodennahen Bereich, dem Dunkelraum, wie erwähnt, nicht verschwindend und verschwindet insbesondere im Plasmaraum. Da aber im Plasmaraum die Raumladungsdichte ρ(x) verschwindet, ist dort das elektrische Potential konstant.

In Fig. 2 ist nun weiter die in Funktion von x beobachtete Beschichtungsrate R des in einem PECVD-Verfahren abgeschiedenen Schichtmaterials dargestellt. Wie ersichtlich, ist die Beschichtungsrate R im Dunkelraum mit abnehmendem Abstand von der betrachteten Elektrode stark zunehmend, so dass sich, nur die Beschichtungsrate als Optimierungsgrösse betrachtend, das bisher bekannte Vorgehen, nämlich das zu beschichtende Werkstück im Dunkelraum anzuordnen, ohne weiteres anbietet. Allerdings ist in diesem Dunkelraum der Beschichtungsratengradient dR/dx gross, so dass dann, wenn mehrere elektrisch nicht leitende Flächen gleichzeitig zu beschichten sind, peinlich darauf zu achten ist, dass diese Flächen auch auf dem selben x-Koordinatenwert liegen.

Aus Fig. 2 wird nun aber ersichtlich, dass die Beschichtungsrate R im Plasmaraum nicht verschwindet, jedoch der Gradient dR/dx. Damit wird hier die Beschichtungsrate weitgehend unabhängig von der x-Koordinate, d.h. es können hier Flächen in x-Richtung beliebig gestaffelt angeordnet werden, und sie werden trotzdem gleich beschichtet.

Betrachtet man nun weiter die auf der Elektrode 11 gemäss Fig. 1 für das herkömmliche Anordnen von Werkstücken zur Verfügung stehende Oberfläche 23 und vergleicht sie mit dem nun zum Anordnen von Werkstücken erfindungsgemäss zur Verfügung stehenden Plasmaraum, so wird ersichtlich, dass mit der der Erfindung zugrundegelegten Erkenntnis, d.h. Ausnützung des Plasmaraumes für die PECVD-Beschichtung, das zum Anordnen gleichzeitig und gleich zu beschichtender Flächen zur Verfügung stehende Platzangebot wesentlich grösser ist, insbesondere wenn man bedenkt, dass nun Werkstücke, in x-Richtung gestaffelt, dabei auch lateral aufeinander ausgerichtet, angeordnet werden können, da sie sich auch dann, bezüglich Beschichtung, nicht abdecken.

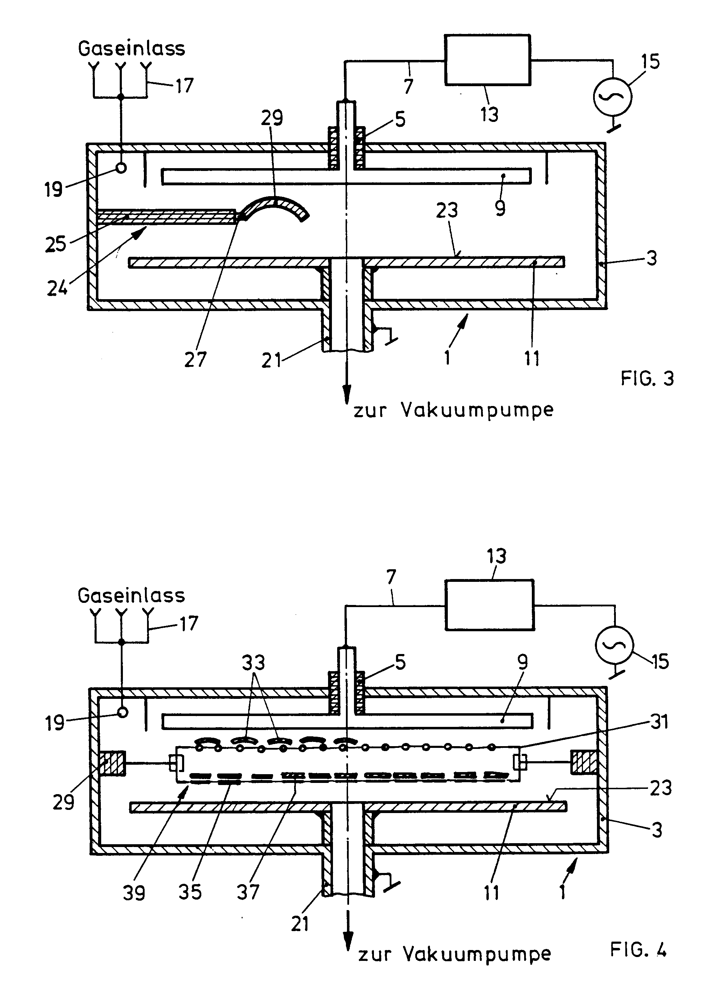

In Fig. 3 ist, ausgehend von der Darstellung in Fig. 1 und den Erläuterungen im Zusammenhang mit Fig. 2, dargestellt, wie in einer Variante des erfindungsgemässen Vorgehens die Eigenschaft, dass nämlich der Beschichtungsratengradient in Entladungsrichtung im Plasmaraum verschwindet, ausgenützt wird. Werkstükke, wie optische Linsen, Filtergläser etc., die durch das PECVD-Verfahren beschichtet werden sollen, werden mit einer Halteanordnung im Plasmaraum angeordnet, und zwar elektrisch isoliert bezüglich auf Potential gelegter Anlageteile, wie Elektrode 9, Kammer und Gegenelektrode 3 bzw. 11.

Hierzu ist eine Isolationsstrecke 25 an der Halterung 24 vorgesehen und endständig ein wie auch immer und je nach Werkstück ausgebildetes Halteorgan 27, um das zweiseitig bzw. allseitig zu beschichtende Werkstück 29 an den mindestens zwei gleichzeitig und gleich zu beschichtenden Flächen frei im Plasmaraum zu positionieren. In Fig. 3 ist das Anordnen lediglich eines Werkstückes 29 dargestellt. Es versteht sich aber von selbst, dass wie durch radial in die Kammer einragende Haltevorrichtungen 24 eine grosse Anzahl von Werkstücken 29 für die gleichzeitig zweiseitige Beschichtung während eines Prozesses angeordnet werden kann.

In Fig. 4 ist wiederum an der anhand von Fig. 1 beispielsweise dargestellten Kammer gezeigt, wie weiter grundsätzlich eine Vielzahl gleichzeitig und gleich zu beschichtender Werkstücke vorgesehen wird. Wie beschrieben bezüglich auf Potential liegender Anlageteile isoliert, wie bei 30 schematisch dargestellt, ist eine Halteanordnung vorgesehen, beispielsweise mit einer Netzstruktur 31, worauf allseitig und insbesondere zweiseitig gleichzeitig zu beschichtende, allenfalls zusätzlich noch gewölbte oder gekrümmte bzw. beliebig geformte Werkstücke 33, wie Linsen, abgelegt sind.

Auf einer unteren netzartigen Struktur 35 ist nun beispielsweise eine Anzahl planer Werkstücke 37 abgelegt, wobei die netzartige Struktur so ausgebildet ist, dass die eine Oberfläche der hier planen Werkstücke 37 auf der Struktur aufliegt und mithin nicht beschichtet wird. Gegebenenfalls werden die zwei Netzstrukturen aus isolierendem Material gefertigt oder, wie bei 39 schematisch dargestellt, mindestens voneinander isoliert, um die Potentialverteilung im Plasmaraum durch galvanische Ausgleichsströme nicht zu stören.

Soll nicht nur in x-Richtung, sondern auch in Lateralrichtung (in Fig. 1 mit y gestrichelt angedeutet) in einem grösseren Bereich eine gleichmässige gleichzeitige Beschichtung sichergestellt werden, so kann es notwendig sein, die Verteilung des Plasmas zu beeinflussen, wie zu homogenisieren und auszudehnen, um einen möglichst grossen erfindungsgemäss ausnützbaren Raum zu erhalten. Dies wird grundsätzlich, und wie in Fig. 1 schematisch eingetragen, durch Anlegen eines magnetischen Induktionsfeldes B̅ erreicht. Ein solches Feld B̅ wird durch Vorsehen einer Permanent- und/oder Elektromagnetanordnung, vorzugsweise ausserhalb der Kammer, erzeugt.

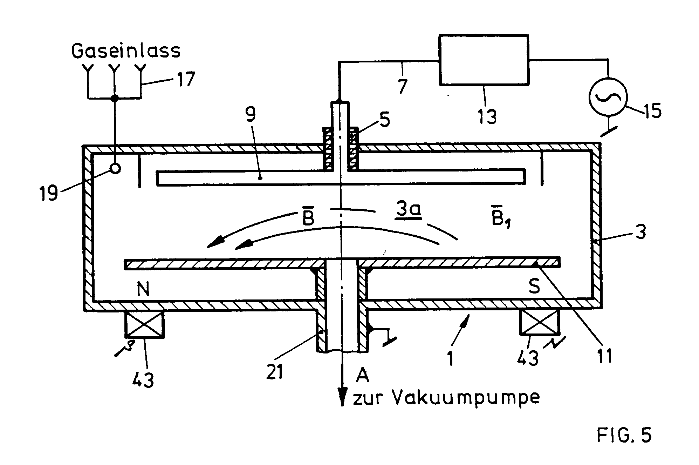

Es wurden, wie in Fig. 5 dargestellt, Permanentmagnete 43 im Bereich der Elektrode 11 ausserhalb der Kammer 3, bezüglich der Achse A gleichmässig verteilt, vorgesehen.

### Beispiele:

In einem kapazitiv gekoppelten Hf-Reaktor der Art, wie in den Figuren dargestellt, mit 7cm Plattenabstand zwischen den Elektroden 9 und 11, wurde eine Glasplatte 50 x 50 x 2mm etwa über der Vakuumabsaugung 21 und etwa mittig zwischen den Elektroden positioniert und durch Plasmapolymerisation von Dimethyldiaethoxylsilan bei einem Gasfluss von 31 sccm, 600 Watt Hf-Leistung, bei 7 mTorr-Druck während 30 Min beschichtet. Beide Seiten der Glasplatte waren darnach mit einer Schicht von 550 nm Dicke beschichtet.

Im selben Reaktor wurde eine Kunststofflinse mit ⌀ 65mm und einer Krümmung 1/R′ von 0,013cm⁻¹ exzentrisch, d.h. lateral in y-Richtung verschoben, bis auf etwa das halbe Radiusmass der Elektroden 9, 11 positioniert. Es wurden Permanentmagnete, wie in Fig. 5 dargestellt, vorgesehen, so dass am Substrat bzw. im Bereich der Kunststofflinse ein Magnetfeld von 10 bis 100 Gauss entstand. Bei einem Druck von 7 mTorr, einem Gasfluss von 31 sccm und 600 Watt Hf-Leistung, wiederum bei 13,56 MHz, wurden beide Seiten mit der Abscheiderate von 38 nm/Min beschichtet. Ein krümmungsbedingter Schichtdickenunterschied vom Zentrumsbereich der Linse zu deren Peripherie konnte nicht festgestellt werden.

In einem gleichen Reaktor mit Plattenabstand 5 cm wurde weiter ein Würfel aus Polycarbonat mit Kantenlänge 1 x 1 x 1 cm koaxial positioniert und wiederum durch Plasmapolymerisation von Dimethyldiaethoxylsilan bei einem Gasfluss von 30 sccm, bei 0,15 mbar-Druck und 1000 Watt Hf-Leistung (13,56 MHz) während 45 Min beschichtet. Der Würfel wies eine allseitige Beschichtung von 700 nm auf.

Obwohl keinesfalls auf das erfindungsgemässe Vorgehen einschränkend auszulegen, wird dem Fachmann angeraten, vorerst den Prozess erfindungsgemässer Art mit den erprobten Druckwerten von 1 mTorr bis 1 Torr vorzunehmen.

## Patentansprüche

1. Verfahren zum gleichzeitigen plasmaunterstützten chemischen Beschichten von räumlich versetzten Oberflächenbereichen eines Werkstückes, dadurch gekennzeichnet, dass man zum im wesentlichen gleichmässigen Beschichten der Oberflächenbereiche eines einheitlichen Werkstückes das einheitliche Werkstück bezüglich elektrischem Potential freischwebend in den Mittenbereich eines zwischen zwei Elektroden einer Vakuumbehandlungskammer gebildeten Entladungsraumes einbringt und zwischen den Elektroden eine Entladung erzeugt.

2. Verfahren nach Anspruch 1, dadurch gekennzeichnet, dass je einer der Oberflächenbereiche einer der Elektroden zugewandt angeordnet wird.

3. Verfahren nach Anspruch 1 oder 2, dadurch gekennzeichnet, dass die Oberflächenbereiche gewölbt sind.

4. Verfahren nach einem der Ansprüche 1 bis 3, dadurch gekennzeichnet, dass der eine Oberflächenbereich konkav, der andere konvex gebogen ist.

5. Verfahren nach einem der Ansprüche 1 bis 4, dadurch gekennzeichnet, dass man gleichzeitig mehrere der Werkstücke beschichtet, dabei vorzugsweise die Werkstücke in Richtung der Entladung versetzt anordnet.

6. Verfahren nach einem der Ansprüche 1 bis 5, dadurch gekennzeichnet, dass man die Entladung zusätzlich mittels eines Magnetfeldes im Entladungsraum unterstützt.

7. Verfahren nach einem der Ansprüche 1 bis 6, dadurch gekennzeichnet, dass als Dampf eine metallorganische Verbindung verwendet wird und durch Polymerisation eine Schutzschicht gegen mechanische und chemische Einflüsse auf dem Werkstück aufgebracht wird.

8. Verfahren nach einem der Ansprüche 1 bis 7, dadurch gekennzeichnet, dass man das Plasma mittels kapazitiver Einkopplung einer Wechselspannung erzeugt, vorzugsweise einer Hochfrequenzspannung.

9. Verfahren nach einem der Ansprüche 1 bis 8, dadurch gekennzeichnet, dass man die räumliche Ausbreitung des Plasmaraumes mittels eines Magnetfeldes beeinflusst.

10. Anlage zur gleichzeitigen plasmaunterstützten chemischen Beschichtung von räumlich versetzten Oberflächenbereichen eines Werkstückes mit mindestens zwei Elektroden (9, 11) zur Erzeugung einer Entladung in einer Vakuumprozesskammer (1), dadurch gekennzeichnet, dass Halteorgane zwischen den zwei Elektroden angeordnet sind und bezüglich auf definiertem elektrischem Potential gelegter Anlageteile isoliert sind, die zur Aufnahme von Werkstücken ausgebildet sind, derart, dass die Oberflächenbereiche für eine Beschichtung freiliegen, um sie im wesentlichen gleich zu beschichten.

11. Anlage nach Anspruch 10, dadurch gekennzeichnet, dass die Halteorgane zur Aufnahme mehrerer Werkstücke ausgebildet sind.

12. Anlage nach einem der Ansprüche 10 oder 11, dadurch gekennzeichnet, dass Felderzeugungsorgane (43) vorgesehen sind, welche in der Prozesskammer ein Magnetfeld (B̅₁) erzeugen.

13. Anlage nach einem der Ansprüche 10 bis 12, dadurch gekennzeichnet, dass ein AC-Generator (15), vorzugsweise ein Hochfrequenzgenerator, mit mindestens einer der Elektroden (9) kapazitiv gekoppelt ist.

14. Anlage nach einem der Ansprüche 10 bis 13, dadurch gekennzeichnet, dass die Elektroden in der Art eines Plattenkondensators angeordnet sind.

15. Anlage nach Anspruch 12, dadurch gekennzeichnet, dass die Organe Elektromagnete und/oder Permanentmagnete (43) umfassen, die vorzugsweise ausserhalb der Prozesskammer angeordnet sind.

16. Anlage nach Anspruch 15, dadurch gekennzeichnet, dass die Magnete im wesentlichen axial-symmetrisch zu einer Symmetrieachse (A) der Elektrodenanordnung angeordnet sind.

17. Anlage nach einem der Ansprüche 10 bis 16, dadurch gekennzeichnet, dass die Halteorgane (25, 31) bewegbar ausgebildet sind.

18. Anwendung des Verfahrens nach einem der Ansprüche 1 bis 9 oder der Anlage nach einem der Ansprüche 10 bis 17 für die Beschichtung von Substraten mit planen Oberflächen.

19. Anwendung des Verfahrens nach einem der Ansprüche 1 bis 9 oder der Anlage nach einem der Ansprüche 10 bis 17 zur Beschichtung von Substraten mit gewölbten Oberflächen.

20. Anwendung des Verfahrens nach einem der Ansprüche 1 bis 9 oder der Anlage nach einem der Ansprüche 10 bis 17 für die Beschichtung von Kunststoffsubstraten mit optisch transparenten und abriebfesten Schutzschichten.

## Claims

1. Process for simultaneous plasma-enhanced chemical coating of physically offset surface areas of a workpiece, characterised in that for essentially even coating of the surface areas of a uniform work piece, the uniform workpiece is placed freely suspended with regard to electrical potential in the centre area of a discharge chamber formed between two electrodes of a vacuum processing chamber and a discharge is generated between the electrodes.

2. Process according to Claim 1, characterised in that one surface area is arranged facing one of the electrodes.

3. Process according to Claim 1 or 2, characterised in that the surface areas are curved.

4. Process according to any of Claims 1 to 3, characterised in that one surface area is concave and the other convex.

5. Process according to any of Claims 1 to 4, characterised in that several workpieces are coated simultaneously, where preferably the workpieces are arranged offset in the direction of discharge.

6. Process according to any of Claims 1 to 5, characterised in that the discharge is also supported by a magnetic field in the discharge chamber.

7. Process according to any of Claims 1 to 6, characterised in that a metal organic compound is used as a vapour and a protective layer against mechanical and chemical influences is applied to the workpiece by polymerisation.

8. Process according to any of Claims 1 to 7, characterised in that the plasma is generated by means of capacitive coupling of an alternating voltage, preferably a high frequency voltage.

9. Process according to any of Claims 1 to 8, characterised in that the physical extent of the plasma area is influenced by means of a magnetic field.

10. Device for simultaneous plasma-enhanced chemical coating of physically offset surface areas of a workpiece with at least two electrodes (9, 11) to generate a discharge in a vacuum processing chamber (1), characterised in that holding elements are arranged between the two electrodes and insulated from device parts exposed to the defined electrical potential and intended to hold the workpiece such that the surface area for coating is left exposed in order to be coated essentially evenly.

11. Device according to Claim 10, characterised in that the holding elements are designed to hold several workpieces.

12. Device according to any of Claims 10 or 11, characterised in that field generation elements (43) are provided which generate a magnetic field (B̅₁) in the process chamber.

13. Device according to any Claims 10 to 12, characterised in that an AC generator (15), possibly a high frequency generator, is capacitively coupled to at least one of the electrodes (9).

14. Device according to any of Claims 10 to 13, characterised in that the electrodes are arranged in the manner of a plate capacitor.

15. Device according to Claim 12, characterised in that the elements comprise electromagnets and/or permanent magnets (43), which are preferably arranged outside the process chamber.

16. Device according to Claim 15, characterised in that the magnets are arranged essentially axially symmetrical to an axis of symmetry (A) of the electrode arrangement.

17. Device according to any of Claims 10 to 16, characterised in that the holding elements (25, 31) are designed to be movable.

18. Use of a process according to any of Claims 1 to 9 or the device according to any of Claims 10 to 17 for coating substrates with flat surfaces.

19. Use of the process according to any of Claims 1 to 9 or the device according to any of Claims 10 to 17 for coating substrates with curved surfaces.

20. Use of the process according to any of Claims 1 to 9 or the device according to any of Claims 10 to 17 for coating plastic substrates with optically transparent and abrasion-resistant protective coatings.

## Revendications

1. Procédé pour le revêtement chimique simultané amélioré par plasma de zones superficielles d'une pièce décalées dans l'espace, caractérisé en ce que, pour revêtir sensiblement régulièrement les zones superficielles d'une pièce uniforme, on place ladite pièce uniforme, avec un potentiel électrique flottant, dans la zone centrale d'un espace de décharge défini entre deux électrodes d'une chambre de traitement sous vide, et on génère une décharge entre les électrodes.

2. Procédé selon la revendication 1, caractérisé en ce qu'une zone superficielle est tournée vers l'une des électrodes.

3. Procédé selon la revendication 1 ou 2, caractérisé en ce que les zones superficielles sont bombées.

4. Procédé selon l'une des revendications 1 à 3, caractérisé en ce qu'une zone superficielle est concave tandis que l'autre est convexe.

5. Procédé selon l'une des revendications 1 à 4, caractérisé en ce qu'on revêt simultanément plusieurs pièces, les pièces étant de préférence décalées dans le sens de la décharge.

6. Procédé selon l'une des revendications 1 à 5, caractérisé en ce qu'on renforce la décharge, en supplément, à l'aide d'un champ magnétique dans l'espace de décharge.

7. Procédé selon l'une des revendications 1 à 6, caractérisé en ce qu'on utilise, comme vapeur, un composé organométallique, et on applique sur la pièce, par polymérisation, une couche de protection contre les influences mécaniques et chimiques.

8. Procédé selon l'une des revendications 1 à 7, caractérisé en ce qu'on génère le plasma à l'aide d'un couplage capacitif d'une tension alternative, de préférence d'une tension à haute fréquence.

9. Procédé selon l'une des revendications 1 à 8, caractérisé en ce qu'on influence l'extension dans l'espace de l'espace de plasma à l'aide d'un champ magnétique.

10. Installation pour le revêtement chimique simultané amélioré par plasma de zones superficielles d'une pièce décalées dans l'espace, comportant au moins deux électrodes (9, 11) pour générer une décharge dans une chambre de traitement sous vide (1), caractérisée en ce que des organes de support sont disposés entre les deux électrodes et sont isolés par rapport aux éléments de l'installation mis à un potentiel électrique défini, lesquels organes de support sont conçus pour recevoir les pièces de telle sorte que les zones superficielles soient dégagées pour un revêtement, afin qu'elles soient revêtues sensiblement régulièrement.

11. Installation selon la revendication 10, caractérisée en ce que les organes de support sont conçus pour recevoir plusieurs pièces.

12. Installation selon l'une des revendications 10 ou 11, caractérisée en ce qu'il est prévu des organes générateurs de champ (43) qui génèrent un champ magnétique (B̅₁) dans la chambre de traitement.

13. Installation selon l'une des revendications 10 à 12, caractérisée en ce qu'un générateur c.a. (15), de préférence un générateur à haute fréquence, est couplé de manière capacitive à l'une au moins des électrodes (9).

14. Installation selon l'une des revendications 10 à 13, caractérisée en ce que les électrodes sont disposées à la manière d'un condensateur à plaques.

15. Installation selon la revendication 12, caractérisée en ce que les organes comprennent des électroaimants et/ou des aimants permanents (43) qui sont disposés de préférence à l'extérieur de la chambre de traitement.

16. Installation selon la revendication 15, caractérisée en ce que les aimants sont disposés de façon sensiblement axisymétrique par rapport à un axe de symétrie (A) du dispositif d'électrodes.

17. Installation selon l'une des revendications 10 à 16, caractérisée en ce que les organes de support (25, 31) sont conçus pour être mobiles.

18. Application du procédé selon l'une des revendications 1 à 9 ou de l'installation selon l'une des revendications 10 à 17 pour le revêtement de substrats à surfaces planes.

19. Application du procédé selon l'une des revendications 1 à 9 ou de l'installation selon l'une des revendications 10 à 17 pour le revêtement de substrats à surfaces bombées.

20. Application du procédé selon l'une des revendications 1 à 9 ou de l'installation selon l'une des revendications 10 à 17 pour le revêtement de substrats en matière plastique avec des couches de protection optiquement transparentes et résistantes à l'usure.
